# FASCICULE DE BREVET EUROPEEN

(11) **EP 2 850 655 B1**
(45) Date de publication et mention de la délivrance du brevet: **12.02.2020**
(21) Numéro de dépôt: 13724222.8
(22) Date de dépôt: 14.05.2013
(51) Int. Cl.: H01L 23/29

(54) **MODULE ÉLECTRONIQUE D'ÈQUIPEMENT AÉRONAUTIQUE EMBARQUÉ ET ÉQUIPEMENT AÉRONAUTIQUE DE VÉHICULE AÉRONAUTIQUE**
ELEKTRONISCHES MODUL FÜR EIN FAHRZEUGGEBUNDENES AERONAUTISCHES AUSRÜSTUNGSTEIL SOWIE AERONAUTISCHES AUSRÜSTUNGSTEIL FÜR EIN AERONAUTISCHES FAHRZEUG
ELECTRONIC MODULE FOR A PIECE OF VEHICLE-BORNE AERONAUTIC EQUIPMENT AND A PIECE OF AERONAUTIC EQUIPMENT FOR AN AERONAUTIC VEHICLE

(30) Priorité: 15.05.2012 FR 1254439
(43) Date de publication de la demande: 25.03.2015
(73) Titulaire: Safran Electronics & Defense, 92100 Boulogne-Billancourt (FR)
(72) Inventeur: RIOU, Jean-Christophe, F-92100 Boulogne-Billancourt (FR); PEYRARD, Michel, F-92100 Boulogne-Billancourt (FR); BAILLY, Eric, F-92100 Boulogne-Billancourt (FR)
(74) Mandataire: Lavialle, Bruno François Stéphane
(86) Numéro de dépôt international: PCT/EP2013/059960
(87) Numéro de publication internationale: WO 2013/171226

(56) Documents cités:
- US-A- 3 749 601
- US-A- 4 946 549
- US-A- 5 455 195
- US-A1- 2010 133 688
- James J Licari ET AL: "HYBRID MICROCIRCUIT TECHNOLOGY HANDBOOK Materials, Processes, Design, Testing and Production", HYBRID MICROCIRCUIT TECHNOLOGY HANDBOOK, 1 janvier 1998 (1998-01-01), pages 288-294, XP055052607, New Jersey, US ISBN: 978-0-81-551423-7 Extrait de l'Internet: URL:http://lib.semi.ac.cn:8080/tsh/dzzy/eb ooks/full/fn136.pdf [extrait le 2013-02-06]
- P. K. WU ET AL: "Surface reaction and stability of parylene N and F thin films at elevated temperatures", JOURNAL OF ELECTRONIC MATERIALS, vol. 24, no. 1, 1 janvier 1995 (1995-01-01), pages 53-58, XP055052600, ISSN: 0361-5235, DOI: 10.1007/BF02659727
- FREYTAG J ET AL: "Wire bonding technique for high temperature applications", PROCEEDINGS / 1998 5TH INTERNATIONAL CONFERENCE ON SOLID-STATE AND INTEGRATED CIRCUIT TECHNOLOGY : OCTOBER 21 - 23, 1998, BEIJING, CHINA, IEEE, PISCATAWAY, NJ, USA, 21 octobre 1998 (1998-10-21), pages 219-221, XP010347006, DOI: 10.1109/ICSICT.1998.785858 ISBN: 978-0-7803-4306-1

## Description

La présente invention concerne un module électronique d'équipement aéronautique embarqué et un équipement de véhicule aéronautique tel qu'un aéronef.

Il est connu que les aéronefs et leurs équipements sont soumis, au cours de leur exploitation à des sollicitations mécaniques et thermiques dont la combinaison met à rude épreuve les structures desdits aéronefs et de leurs équipements. Ces contraintes s'appliquent en tout ou partie tant lors du vol proprement dit que lors des phases de décollage, d'atterrissage, de freinage voire de roulage au sol et dans des environnements variés en fonction des zones géographiques d'exploitation des aéronefs. Il en résulte une grande amplitude des contraintes qui rend ardue la conception des aéronefs et de leurs équipements.

Les amplitudes thermiques considérées s'étendent, par exemple au voisinage d'une roue d'un aéronef, de - 60°C (pendant plusieurs heures en vol) à une valeur pouvant monter dans certains cas jusqu'à + 180°C voire même 200°C à l'atterrissage (durée à température élevée de l'ordre de 1 heure au moins) en raison de l'élévation de température du frein de la roue, et ce pour des milliers de cycles. A la température, s'ajoutent les chocs et les vibrations à l'atterrissage qui peuvent engendrer une détérioration mécanique des équipements.

Les modules et circuits électroniques sont particulièrement sensibles à ce type de sollicitations. En particulier :
- les variations de température provoquent des cycles de dilatations et contractions des composants des circuits,
- une exposition prolongée (en durée cumulée) à température élevée génère des composés intermétalliques entre les matériaux en présence qui fragilisent les assemblages et peuvent entraîner des ruptures soudaines en chocs ou en cycles thermique,
- en basse température les matériaux rigides peuvent montrer des faiblesses en cas de chocs (transitions ductiles / fragiles).

De plus, lorsque ces composants sont constitués de matériaux différents comme c'est la plupart du temps le cas, apparaissent des dilatations et contractions différentielles faisant naître des contraintes dans les assemblages et les composants hétérogènes.

Certains circuits sont noyés dans une matière plastique telle qu'une résine époxy pour les protéger de l'humidité. Compte tenu de l'épaisseur d'époxy nécessaire à cette fonction de protection, les dilatations différentielles sont telles qu'elles entraînent une rupture de la liaison entre l'époxy et le circuit autorisant le passage de l'humidité ou engendrant des contraintes importantes sur la liaison des composants de surface au circuit.

Il existe également des modules comportant des circuits enfermés dans des boîtiers hermétiques sous gaz neutre ou sous vide. Ceci permet de réduire les problèmes de dilatations différentielles et de vieillissement en général mais augmente considérablement le poids, l'encombrement, la complexité, et donc le coût de ces modules tout en compliquant également les opérations de contrôle nécessaires.

Le document US 3749601 A divulgue un module électronique comportant un circuit hybride en céramique recouvert d'un revêtement de protection en poly-p-xylylène.

Un des objectifs de l'invention est de fournir un moyen pour limiter l'influence des variations de températures, et plus particulièrement des dilatations différentielles, sur des modules électroniques destinées aux applications aéronautiques.

A cet effet, on prévoit, selon l'invention, un module électronique d'équipement aéronautique embarqué comportant un circuit hybride en couches épaisses recouvert d'un revêtement d'étanchéité de poly-p-xylylène.

Le poly-p-xylylène est déposé en phase vapeur sous vide et possède des propriétés permettant au revêtement d'étanchéité d'assurer sa fonction même avec une épaisseur très faible. De part cette faible épaisseur, les effets induits par les dilatations différentielles sont très limités et n'engendrent pas de contraintes suffisantes pour provoquer la rupture de liaison des composants de surface au circuit ou engendrer des passages d'humidité à l'interface entre le circuit et le revêtement. Au contraire, ce matériau permet de prolonger la durée de vie notamment des câblages par wirebondings.

Par ailleurs, les variations de température favorisent les ruptures au niveau des liaisons électriques et mécaniques des éléments conducteurs du circuit. On s'est aperçu que la rupture intervenait plus particulièrement lorsque des atomes d'un métal d'un des éléments conducteurs du circuit se diffusent vers un métal d'un autre élément conducteur du circuit de telle manière que les atomes de ces métaux se combinent pour former un composé intermétallique de plus faible résistance mécanique. Ceci est particulièrement fréquent avec l'or, l'aluminium et l'étain qui possèdent des caractéristiques physicochimiques (potentiel d'oxydoréduction, structure cristalline, vitesse de diffusion dans d'autres entités) propices à accélérer ces phénomènes.

De préférence, le circuit comprend au moins un premier élément conducteur et un deuxième élément conducteur, le premier élément comportant au moins un premier métal éventuellement différent d'un deuxième métal du deuxième élément et étant relié électriquement et mécaniquement à un deuxième élément conducteur par une liaison de telle manière à s'opposer à une diffusion du premier métal vers le deuxième métal.

On limite ainsi la formation de composés intermétalliques susceptibles d'altérer la résistance électrique et mécanique de la liaison des éléments conducteurs entre eux.

Selon un premier mode de réalisation, les métaux sont sélectionnés pour avoir une masse atomique suffisamment élevée et/ou des coefficients d'électronégativité suffisamment proches pour limiter la diffusion d'un des métaux vers l'autre.

La diffusion d'un des métaux vers l'autre est d'autant plus rapide que celui-ci a un poids atomique faible et que les métaux ont des coefficients d'électronégativité éloignés l'un de l'autre. Un choix judicieux des métaux permet de jouer sur l'un et/ou l'autre de ces paramètres pour ralentir la diffusion du métal.

Selon un deuxième mode de réalisation, le premier élément comprend un troisième métal pour former avec le deuxième métal au niveau de la liaison une barrière métallique s'opposant à une migration du premier métal vers le deuxième métal.

On favorise ainsi la création d'un composé intermétallique dont la résistance mécanique est supérieure à celle du composé intermétallique qui serait formé par le premier métal avec le deuxième métal. Le composé intermétallique favorisé va constituer une barrière métallurgique s'opposant à la migration du premier métal.

De préférence, le revêtement a une épaisseur totale comprise entre 8 µm et 20 µm, et, avantageusement, le revêtement a une épaisseur totale comprise entre 10 µm et 15 µm environ.

Cette épaisseur est optimale pour :
- d'une part limiter les contraintes ;
- d'autre part, empêcher une électromigration d'un matériau sous-jacent (par exemple l'argent) lorsque le module est soumis à de l'humidité, éventuellement en présence de soufre.

Avantageusement encore, le module comprend au moins un composant fixé par de la colle sur un support, la colle ayant une partie libre dégagée du support et du composant et recouverte en totalité du revêtement de protection.

Le revêtement protège la colle de l'humidité (qui peut conduire à la destruction de liaisons chimiques au sein de la colle et/ou à l'interface entre la colle et les pièces collées), ce qui permet de renforcer la résistance thermomécanique du collage.

L'invention a également pour objet un équipement aéronautique comportant le module électronique de l'invention.

D'autres caractéristiques et avantages de l'invention ressortiront à la lecture de la description qui suit de modes de réalisation particuliers non limitatifs de l'invention, qui est seulement limitée par les revendications.

Il sera fait référence aux dessins annexés, parmi lesquels :
- la figure 1 est une vue schématique partielle et en coupe illustrant les différents assemblages présents sur un module électronique aéronautique conforme à l'invention,
- la figure 2 est une vue schématique partielle et en coupe d'un câblage par wirebonding d'une puce,
- la figure 3 est une vue de détail en coupe de la liaison d'un composant passif au circuit.

En référence aux figures, l'invention est ici décrite en application à un équipement de véhicule aéronautique mais peut être appliquée à tout module électronique devant fonctionner sur des gammes de températures extrêmes pouvant aller -60°C environ jusqu'à +225°C environ.

Le module électronique objet de l'invention comporte un circuit hybride en céramique 6 recouvert d'un revêtement d'étanchéité 7 de poly-p-xylylène. Le poly-p-xylylène utilisé est par exemple celui commercialisé sous la marque « PARYLENE ». Le poly-p-xylylène est déposé en phase vapeur sous pression de manière à recouvrir en totalité le circuit 6 à l'exception des bornes de raccordement du circuit 6 au système sur lequel il est monté. Le revêtement d'étanchéité 7 a une épaisseur très faible (inférieure ici à 30 µm). De préférence, l'épaisseur du revêtement 7 est comprise entre 8 µm et 20 µm, et avantageusement entre 10 µm et 15 µm.

De manière connue en elle-même, le circuit 6 comporte une âme en céramique supportant des couches conductrices superposées en alternance avec des couches électriquement isolantes et, éventuellement, des couches résistives. Les couches conductrices 8 délimitent des pistes et des composants passifs (résistances, inductances...) et sont formées par une encre conductrice. Les couches conductrices ont des portions 8.1 reliées les unes aux autres par des trous métallisés, des portions 8.2 (plus particulièrement des couches externes du circuit 6) reliées à des fils de liaison 9 par soudage, des portions 8.3 (plus particulièrement des couches externes du circuit 6) reliées à des composants 10 par une brasure 11. Des composants 12 fixés au circuit 6 ont également des plots 13 reliés à des fils de liaison 9 par soudage.

Dans l'invention, lorsqu'un premier élément conducteur doit être relié électriquement et mécaniquement à un deuxième élément conducteur et que le premier élément comporte au moins un premier métal différent d'un deuxième métal du deuxième élément, il est prévu de choisir les métaux et de réaliser la liaison de telle manière à s'opposer à une diffusion du premier métal vers le deuxième métal. Plus précisément, selon deux modes de réalisation :
- les métaux sont sélectionnés pour avoir une masse atomique suffisamment élevée et/ou des coefficients d'électronégativité suffisamment proches pour limiter la diffusion d'un des métaux vers l'autre ;
- le premier élément comprend un troisième métal pour former avec le deuxième métal au niveau de la liaison une double barrière métallique s'opposant à une migration du premier métal vers le deuxième métal ou inversement.

Dans le cas présent, cela se traduit de la manière suivante :
- les pistes sont par exemple en or dopé au palladium avec un taux de ce dernier supérieur ou égal à 1%,
- les fils de liaison 9 sont par exemple en or dopé au palladium avec un taux de ce dernier supérieur ou égal à 1%,
- les plots 14 du composant 10 sont avec une finition à base d'étain sur une barrière de nickel et les plots 13 du composant 12 sont en alliage d'aluminium,
- la brasure 11 est par exemple une brasure à haut point de fusion (HMP pour « high melting point »), comprenant notamment du plomb en majorité, de l'argent et une faible teneur en étain. Cette brasure peut également contenir de l'indium en remplacement de tout ou partie de l'étain.

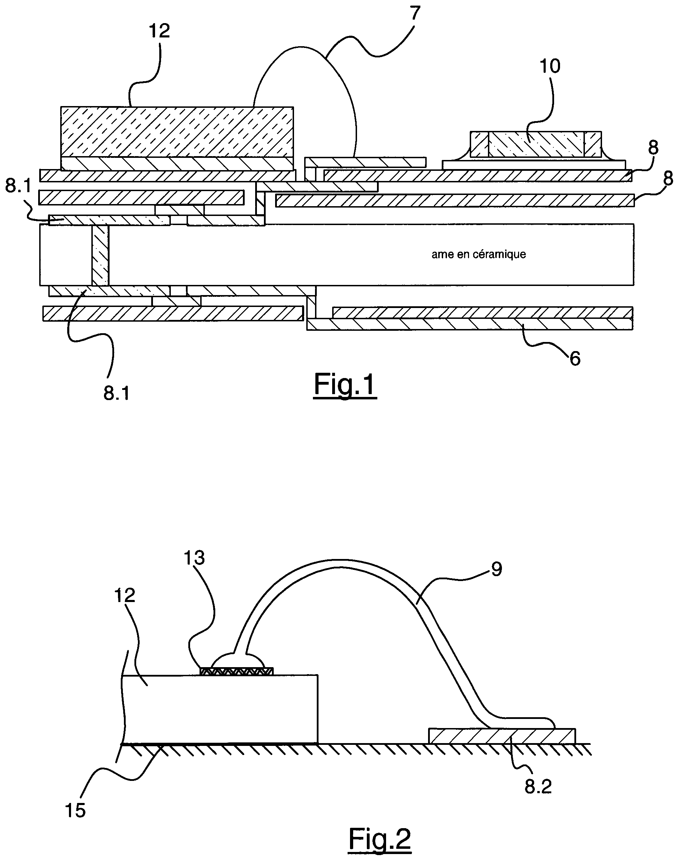

En ce qui concerne la liaison par soudage des fils de liaison 9 aux portions 8.2 des pistes conductrices 8 (« wire-bonding » ou soudage électrique, voir la figure 2), les métaux employés sont tels qu'il n'y a pas de diffusion de l'or ni de formation d'un composé intermétallique néfaste.

Pour la liaison par soudage des fils de liaison 9 aux plots 13 (figure 2 également), le palladium des fils de liaison 9 se combine à l'aluminium des plots 13 pour former une barrière métallurgique s'opposant à la diffusion de l'or vers l'aluminium. Le cuivre de la finition des plots 13 vient quant à lui compléter cette barrière (double barrière métallurgique) et empêcher la diffusion de l'or dans l'aluminium. La barrière métallurgique ainsi créée ralentit la diffusion de l'or voire la bloque. Le composé intermétallique formant la barrière croît plus lentement que celui qui serait formé entre l'aluminium et l'or, ce qui augmente la durée de vie de la soudure en limitant l'évolution de sa structure métallurgique.

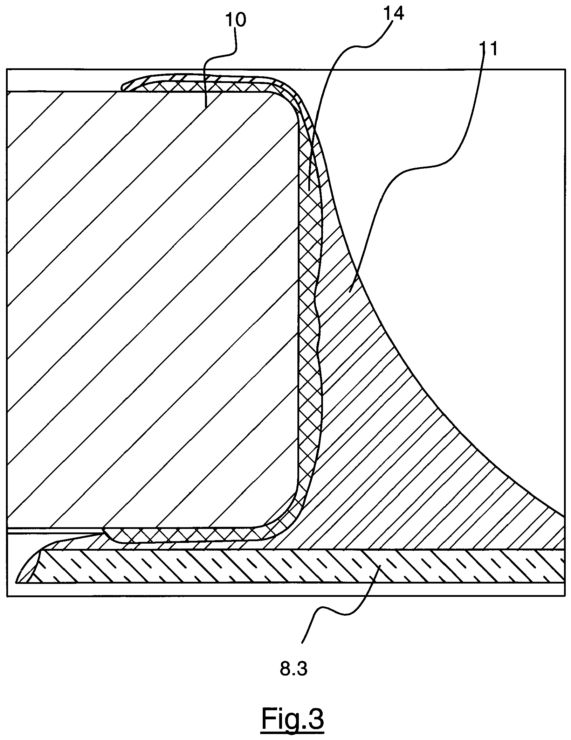

Dans le cas de la liaison des portions 8.3 aux plots de composants 10 par la brasure 11 (figure 3), deux phénomènes sont à considérer respectivement à l'interface entre la brasure 11 et la portion de piste 8.3 et à l'interface entre la brasure 11 et le plot 14 du composant 10. Dans la zone d'interface entre la brasure 11 et la portion 8.3, le palladium et le platine de la piste vont se combiner à l'étain (ou l'indium) de la brasure 11 pour former une double barrière métallurgique s'opposant à la migration de l'or vers l'étain et donc à la dissolution de l'or dans l'étain (élimination des défauts type « voids de Kirkendal »). Dans la zone d'interface entre la brasure 11 et le plot 14 du composant 10, l'étain va former un composé intermétallique avec le nickel de la finition qui, de part ces caractéristiques électronégatives et la taille de sa maille atomique, ralentira considérablement la formation d'intermétalliques à haute température. On notera que l'utilisation d'une brasure à faible teneur en étain réduit la disponibilité de l'étain pour dissoudre l'or ou le nickel.

Dans une variante plus économique, les couches conductrices 8 sont en argent ou un alliage d'argent et les portions externes 8.2 et 8.3 sont recouvertes d'un revêtement résultant de dépôts successifs de nickel, palladium et or ; ou de nickel et d'or ; et / ou les fils de liaison 9 peuvent contenir du cuivre, de l'or et du palladium.

Dans ce cas, comme le cuivre a des atomes de taille relativement importante et présente un coefficient d'électronégativité pas trop éloigné de celui du nickel, les atomes de cuivre diffusent peu vers le nickel tout en ne créant que peu, voire pas, de « void ». Le phénomène est identique vis-à-vis de l'aluminium des plots de puces et du fil contenant du cuivre, de l'or et du palladium. Cette variante permet donc un câblage fiable à haute température de finitions aluminium et alliages, de composants à finition comprenant du nickel, de l'or et du cuivre.

Par ailleurs les finitions de substrat nickel/palladium/or ou nickel/or vont aussi permettre le brasage haute température tel que celui décrit plus avant dans ce document.

Bien entendu, l'invention n'est pas limitée aux modes de réalisation décrits mais englobe toute variante entrant dans le champ de l'invention telle que définie par les revendications.

En particulier, le module peut comprendre des composants collés par exemple au moyen d'une colle silicone haute température ou d'une colle polyimide ou epoxy haute température. Dans ce cas précis :
- les composants 10 auront une finition 14 comprenant de l'argent allié ou de l'or allié,
- les composants 12 auront une finition 13 ou 15 comprenant du silicium, ou de l'argent ou de l'or, allié ou non.

Le module de l'invention peut avoir une structure différente de celle décrite et peut s'appliquer à tout type d'équipement, matériel ou dispositif embarqué sur un aéronef.

## Revendications

1. Module électronique d'équipement aéronautique embarqué prévu pour fonctionner avec une température maximale de +225°C environ, comportant un circuit hybride en céramique recouvert d'un revêtement de protection en poly-p-xylylène, le circuit comprenant au moins un premier élément conducteur et un deuxième élément conducteur, le premier élément comportant au moins un premier métal différent d'un deuxième métal du deuxième élément et étant relié électriquement et mécaniquement au deuxième élément conducteur par une liaison de telle manière à s'opposer à une diffusion du premier métal vers le deuxième métal, et le premier élément comprenant un troisième métal pour former avec le deuxième métal au niveau de la liaison une barrière métallurgique s'opposant à une migration du premier métal vers le deuxième métal, le deuxième élément étant une piste en argent recouverte d'un revêtement superposant successivement du nickel, du palladium et de l'or ou d'un revêtement superposant successivement du nickel et de l'or.

2. Module selon la revendication 1, dans lequel le premier élément est un fil en or dopé au palladium soudé sur le deuxième élément.

3. Module selon la revendication 1, dans lequel le premier élément est un fil en cuivre soudé sur le deuxième élément.

4. Module selon la revendication 1, dans lequel le revêtement a une épaisseur totale comprise entre 8 µm et 20 µm et avantageusement, le revêtement a une épaisseur totale comprise entre 10 µm et 15 µm environ.

5. Module selon la revendication 1, dans lequel le circuit hybride comporte une âme d'alumine supportant des couches conductrices superposées ayant des portions reliées par des trous métallisés.

6. Equipement de véhicule aéronautique comportant un module électronique selon l'une quelconque des revendications précédentes.

7. Utilisation d'un module électronique dans un équipement aéronautique embarqué soumis à des variations de températures comprises entre - 60° C et +225°C environ, le module comportant un circuit hybride en céramique recouvert d'un revêtement de protection en poly-p-xylylène, le circuit comprenant au moins un premier élément conducteur et un deuxième élément conducteur, le premier élément comportant au moins un premier métal différent d'un deuxième métal du deuxième élément et étant relié électriquement et mécaniquement au deuxième élément conducteur par une liaison de telle manière à s'opposer à une diffusion du premier métal vers le deuxième métal, et le premier élément comprenant un troisième métal pour former avec le deuxième métal au niveau de la liaison une barrière métallurgique s'opposant à une migration du premier métal vers le deuxième métal.

8. Utilisation selon la revendication 7, dans lequel les métaux sont sélectionnés pour avoir une masse atomique suffisamment élevée et/ou des coefficients d'électronégativité suffisamment proches pour limiter la diffusion d'un des métaux vers l'autre.

9. Utilisation selon la revendication 7, dans lequel le premier élément est un fil en or dopé au palladium soudé sur le deuxième élément.

10. Utilisation selon la revendication 7, dans lequel le premier élément est un fil en cuivre soudé sur le deuxième élément.

11. Utilisation selon la revendication 9 ou la revendication 10, dans lequel le deuxième élément est un plot en aluminium dopé.

12. Utilisation selon l'une des revendications 9 et 10, dans lequel le deuxième élément est une piste en argent recouverte d'un revêtement superposant successivement du nickel, du palladium et de l'or ou d'un revêtement superposant successivement du nickel et de l'or.

13. Utilisation selon l'une des revendications 9 et 10, dans lequel le deuxième élément est une piste en or dopé au palladium.

14. Utilisation selon la revendication 13, dans lequel le palladium a une teneur de 1% au moins.

15. Utilisation selon la revendication 7, dans lequel le premier métal est de l'or allié et le deuxième élément est une brasure comprenant soit du plomb en majorité, de l'étain et de l'argent, soit du plomb en majorité, de l'indium et de l'argent.

16. Utilisation selon la revendication 15, dans lequel le premier élément est une piste en argent recouverte d'un revêtement superposant successivement du nickel, du palladium et de l'or ou superposant successivement du nickel et de l'or.

17. Utilisation selon la revendication 7, dans lequel le revêtement a une épaisseur totale comprise entre 8 µm et 20 µm et avantageusement, le revêtement a une épaisseur totale comprise entre 10 µm et 15 µm environ.

18. Utilisation selon la revendication 7, dans lequel le circuit hybride comporte une âme d'alumine supportant des couches conductrices superposées ayant des portions reliées par des trous métallisés.

## Patentansprüche

1. Elektronisches Modul für ein aeronautisches Bordausrüstungsteil, das vorgesehen ist, um mit einer maximalen Temperatur von ungefähr +225°C zu arbeiten, umfassend eine Hybridschaltung aus Keramik, die mit einem Schutzüberzug aus Poly-p-xylylen überzogen ist, wobei die Schaltung mindestens ein erstes leitendes Element und ein zweites leitendes Element umfasst, wobei das erste Element mindestens ein erstes Metall umfasst, das von einem zweiten Metall des zweiten Elements verschieden ist, und elektrisch und mechanisch mit dem zweiten leitenden Element über eine Verbindung derart verbunden ist, dass es sich einer Diffusion des ersten Metalls in Richtung des zweiten Metalls widersetzt, und wobei das erste Element ein drittes Metall umfasst, um mit dem zweiten Metall im Bereich der Verbindung eine metallurgische Barriere zu bilden, die sich einer Migration des ersten Metalls in Richtung des zweiten Metalls widersetzt, wobei das zweite Element eine Bahn aus Silber ist, die mit einem Überzug überzogen ist, bei dem nacheinander Nickel, Palladium und Gold übereinander angeordnet sind, oder mit einem Überzug, bei dem nacheinander Nickel und Gold übereinander angeordnet sind.

2. Modul nach Anspruch 1, bei dem das erste Element ein mit Palladium dotierter Draht aus Gold ist, der auf das zweite Element geschweißt ist.

3. Modul nach Anspruch 1, bei dem das erste Element ein Kupferdraht ist, der auf das zweite Element geschweißt ist.

4. Modul nach Anspruch 1, bei dem der Überzug eine Gesamtdicke zwischen 8 µm und 20 µm hat und vorteilhafterweise der Überzug eine Gesamtdicke zwischen ungefähr 10 µm und 15 µm hat.

5. Modul nach Anspruch 1, bei dem die Hybridschaltung eine Aluminiumoxid-Seele umfasst, die übereinander angeordnete leitende Schichten trägt, die Abschnitte haben, die über metallisierte Löcher verbunden sind.

6. Luftfahrzeugausrüstungsteil, umfassend ein elektronisches Modul nach einem der vorhergehenden Ansprüche.

7. Verwendung eines elektronischen Moduls in einem aeronautischen Bordausrüstungsteil, das Temperaturschwankungen zwischen ungefähr -60°C und +225°C ausgesetzt ist, wobei das Modul eine Hybridschaltung aus Keramik umfasst, die mit einem Schutzüberzug aus Poly-p-xylylen überzogen ist, wobei die Schaltung mindestens ein erstes leitendes Element und ein zweites leitendes Element umfasst, wobei das erste Element mindestens ein erstes Metall umfasst, das von einem zweiten Metall des zweiten Elements verschieden ist, und elektrisch und mechanisch mit dem zweiten leitenden Element über eine Verbindung derart verbunden ist, dass es sich einer Diffusion des ersten Metalls in Richtung des zweiten Metalls widersetzt, und wobei das erste Element ein drittes Metall umfasst, um mit dem zweiten Metall im Bereich der Verbindung eine metallurgische Barriere zu bilden, die sich einer Migration des ersten Metalls in Richtung des zweiten Metalls widersetzt.

8. Verwendung nach Anspruch 7, bei der die Metalle so ausgewählt sind, dass sie eine ausreichend hohe Atommasse und/oder ausreichend nahe Elektronegativitätskoeffizienten haben, um die Diffusion von einem der Metalle zum anderen zu beschränken.

9. Verwendung nach Anspruch 7, bei der das erste Element ein mit Palladium dotierter Golddraht ist, der auf das zweite Element geschweißt ist.

10. Verwendung nach Anspruch 7, bei der das erste Element ein Kupferdraht ist, der auf das zweite Element geschweißt ist.

11. Verwendung nach Anspruch 9 oder Anspruch 10, bei der das zweite Element ein Kontaktstück aus dotiertem Aluminium ist.

12. Verwendung nach einem der Ansprüche 9 und 10, bei der das zweite Element eine Bahn aus Silber ist, die mit einem Überzug überzogen ist, bei dem nacheinander Nickel, Palladium und Gold übereinander angeordnet sind, oder mit einem Überzug, bei dem nacheinander Nickel und Gold übereinander angeordnet sind.

13. Verwendung nach einem der Ansprüche 9 und 10, bei der das zweite Element eine mit Palladium dotierte Bahn aus Gold ist.

14. Verwendung nach Anspruch 13, bei der das Palladium einen Gehalt von mindestens 1 % hat.

15. Verwendung nach Anspruch 7, bei der das erste Metall legiertes Gold und das zweite Element ein Lötmittel ist, das entweder überwiegend Blei sowie Zinn und Silber oder überwiegend Blei sowie Indium und Silber umfasst.

16. Verwendung nach Anspruch 15, bei der das erste Element eine Bahn aus Silber ist, die mit einem Überzug überzogen ist, bei dem nacheinander Nickef, Palladium und Gold übereinander angeordnet sind, oder bei dem nacheinander Nickel und Gold übereinander angeordnet sind.

17. Verwendung nach Anspruch 7, bei der der Überzug eine Gesamtdicke zwischen 8 µm und 20 µm und vorzugsweise der Überzug eine Gesamtdicke zwischen ungefähr 10 µm und 15µm umfasst.

18. Verwendung nach Anspruch 7, bei der die Hybridschaltung eine Aluminiumoxid-Seele umfasst, die übereinander gelagerte leitende Schichten trägt, die Abschnitte haben, die über metallisierte Löcher verbunden sind.

## Claims

1. An electronics module for onboard aviation equipment designed to operate at a maximum temperature of about +225°C, the module including a ceramic hybrid circuit covered in a protective coating of poly-p-xylylene, the circuit comprising at least a first conductive element and a second conductive element, the first element including at least a first metal different from a second metal of the second element and being electrically and mechanically connected to the second conductive element by a connection in such a manner as to oppose diffusion of the first metal into the second metal, and the first element including a third metal for co-operating with the second metal at the connection to form a metallurgical barrier opposing migration of the first metal to the second metal, the second element being a track of silver covered in a coating superposing in succession nickel, palladium, and gold, or a coating superposing in succession nickel and gold.

2. A module according to claim 1, wherein the first element is a palladium-doped gold wire welded on the second element.

3. A module according to claim 1, wherein the first element is a copper wire bonded on the second element.

4. A module according to claim 1, wherein the coating has a total thickness comprised between 8 µm and 20 pm, and advantageously, the coating has a total thickness lying in the range 10 µm to 15 µm approximately.

5. A module according to claim 1, wherein the hybrid circuit includes an aluminum core supporting superposed conductive layers having portions that are connected together by plated-through holes.

6. Aircraft equipment including an electronics module according to any preceding claim.

7. The use of an electronics module in onboard aviation equipment that is subjected to temperature variations lying in the range appropriately -60°C to +225°C, the module including a ceramic hybrid circuit covered in a poly-p-xylylene protective coating, the circuit comprising at least a first conductive element and a second conductive element, the first conductive element including at least a first metal different from a second metal of the second element and being electrically and mechanically connected to the second conductive element via a connection in such a manner as to oppose diffusion of the first metal into the second metal, and the first element including a third metal to co-operate with the second metal at the connection to form a metallurgical barrier opposing migration of the first metal to the second metal.

8. A use according to claim 7, wherein the metals are selected to have atomic weights that are sufficiently high and/or electronegativity coefficients that are sufficiently close to limit diffusion of one of the metals into the other.

9. A use according to claim 7, wherein the first element is a palladium-doped gold wire bonded on the second element.

10. A use according to claim 7, wherein the first element is a copper wire wire bonded on the second element.

11. A use according to claim 9 or claim 10, wherein the second element is an aluminum-doped pad.

12. A use according to claim 9 or claim 10, wherein the second element is a silver track covered in a coating comprising superposing in succession nickel, palladium, and gold, or a coating comprising superposing in succession nickel and gold.

13. A use according to claim 9 or claim 10, wherein the second element is a palladium-doped gold track.

14. A use according to claim 13, wherein the palladium content is at least 1%.

15. A use according to claim 7, wherein the first metal is alloyed gold and the second element is solder comprising either a majority of lead, tin, and silver, or else a majority of lead, indium, and silver.

16. A use according to claim 15, wherein the first element is a silver track covered in a coating comprising superposing in succession nickel, palladium, and gold, or a superposing coating comprising in succession nickel and gold.

17. A use according to claim 7, wherein the coating has a total thickness comprised between 8 µm and 20 pm, and advantageously, the coating has a total thickness lying in the range 10 µm to 15 µm approximately.

18. A use according to claim 7, wherein the hybrid circuit includes an aluminum core supporting superposed conductive layers having portions connected together via plated-through holes.
